# EUROPÄISCHE PATENTSCHRIFT

(11) **EP 0 441 268 B1**
(45) Veröffentlichungstag und Bekanntmachung des Hinweises auf die Patenterteilung: **18.01.1995**
(21) Anmeldenummer: 91101393.6
(22) Anmeldetag: 02.02.1991
(51) Int. Cl.: C04B 35/00, H01L 39/12, H01L 39/24

(54) **Verfahren zur Herstellung von Formkörpern aus supraleitendem oxidkeramischem Material**
Process for the production of shaped bodies of superconductive oxide ceramic material
Procédé pour la production de corps façonnés de matériau en céramique oxydée supraconducteur

(30) Priorität: 06.02.1990 DE 4003542
(43) Veröffentlichungstag der Anmeldung: 14.08.1991
(73) Patentinhaber: HOECHST AKTIENGESELLSCHAFT, 65926 Frankfurt am Main (DE)
(72) Erfinder: Kalz, Hans-Jürgen, Dr., W-6237 Liederbach (DE); Hettich, Bernhard, Dr., W-6239 Eppstein/Taunus (DE)

(56) Entgegenhaltungen:
- EP-A- 0 374 392

## Beschreibung

Die Erfindung betrifft ein Verfahren zur Herstellung von Formkörpern aus supraleitendem oxidkeramischem Material, bei dem supraleitendes oxidkeramisches Pulver oder oxidkeramisches Pulver mit einer Bruttozusammensetzung, die gegebenenfalls mit Ausnahme des Sauerstoffgehalts der eines keramischen Supraleiters entspricht, zu einer formbaren Masue aufbereitet wird, die formbare Masse zu einem Grünkörper verformt wird und der Grünkörper gesintert wird.

Keramische Supraleiter gelten als aussichtsreiche Materialien für Bauteile oder Werkstücke im Bereich der Elektrik und Elektronik, da sie zum Teil hohe kritische Temperaturen haben, so daß eine Kühlung mit teurem flüssigem Helium nicht erforderlich ist. Voraussetzung für eine wirtschaftliche, breite Anwendung ist eine hohe kritische Stromdichte I_{c}.

Es gibt bereits Verfahren zur Herstellung von Formkörpern aus supraleitendem oxidkeramischem Material, die hohe kritische Stromdichten haben. So können zum Beispiel supraleitende Schichten auf einkristallinem Strontiumtitanat abgeschieden werden, indem die Metalle verdampft und die Oxide in situ gebildet werden. Mit diesem Verfahren werden kritische Stromdichten von 10⁶A/cm² erreicht. Es hat aber den Nachteil der hohen Herstellkosten, der begrenzten Leiterlänge und der nicht universellen Verwendbarkeit. Ferner ist die Herstellung von supraleitenden Drähten nach der "Pulver-in-Draht-Methode" möglich, bei der ebenfalls hohe Stromdichten von über 10⁴A/cm² erreicht werden. Bei dieser Methode wird ein supraleitendes Pulver in ein dünnes Silberrohr eingebracht und dann wird das Rohr gezogen. Mit diesem Verfahren ist nur die Herstellung von Drähten, aber nicht die Herstellung von beliebigen Formkörpern, wie zum Beispiel Bändern oder kompakten Bauteilen möglich.

Bei der Herstellung von Formkörpern nach in der technischen Keramik herkömmlichen Formgebungsverfahren erreicht man bisher nur geringe kritische Stromdichten von nicht über 10³A/cm². Meistens liegen die gemessenen Werte noch tiefer und erreichen nicht einmal Werte von 500 A/cm². Verantwortlich für die niedrigen kritischen Stromdichten sind die geringe Sinterdichte und die "weak-links" in den keramischen Supraleitern.

Bei den bekannten Verfahren mit herkömmlicher Formgebung wird von feinen keramischen supraleitenden Pulvern mit durchschnittlichen Korngrößen kleiner als 50 »m, bevorzugt kleiner als 30 »m ausgegangen oder von ultrafeinen Pulvern mit durchschnittlichen Korngrößen von 0,1 »m oder darunter. Diese supraleitenden Pulver werden in an sich bekannter Weise aus den pulverförmigen Oxiden, Carbonaten und Nitraten in den entsprechenden stöchiometrischen Zusammensetzungen durch Mischen und Erhitzen in Sauerstoffatmosphäre hergestellt.

Die Aufbereitung der supraleitenden Pulver zu den formbaren Massen richtet sich nach dem geplanten Formgebungsverfahren. Für die Herstellung von Formkörpern durch das Foliengießverfahren werden die Pulver in einem Dispersionsmittel unter Zusatz eines Dispergators dispergiert und dann in einem weiteren Schritt mit einem Bindemittel versehen. In der Regel führt man derartigen formbaren Massen noch Weichmacher zu. Die Aufbereitung erfolgt so, daß Foliengießmassen mit Viskositäten im Bereich von 3000 bis 8000 mPa.s entstehen. Die Foliengießmase läuft aus einem Behälter am Ende eines Bandes durch einen verstellbaren Spalt kontinuierlich auf das Band, wird getrocknet und in Sauerstoffatmosphäre erhitzt. Solche Foliengießverfahren zur Herstellung supraleitender Folien werden zum Beispiel in EP-A0 283 197 und EP-A0 291 034 beschrieben.

Aus der EP-A0 288 236 ist ein Verfahren bekannt, bei dem Rohmaterialien in Form ultrafeiner Pulver(0,1 »m oder weniger) mit bestimmter stöchiometrischer Zusammensetzung dispergiert und gemischt werden, die Mischung in Sauerstoffatmosphäre erhitzt wird und das erhaltende supraleitende Pulver in einem Dispersionsmittel unter Zusatz eines Dispergators zu einem Schlicker verarbeitet wird. Der Schlicker wird dann in eine Form gegossen und nach der Verfestigung aus der Form entfernt. Der Grünkörper wird anschließend gesintert.

Soll die Formgebung durch Spritzguß, Extrusion oder Pressen erfolgen, so werden zunächst dünnflüssige Schlicker hergestellt mit Viskositäten kleiner als 500 mPa.s. Diese Schlicker werden dann zu einem rieselfähigen Pulver sprühgetrocknet, das dann direkt zum gewünschten Formkörper trockengepreßt oder unter Zusatz geringer Mengen an Bindern, Plastifizierern und Gleitmitteln spritzgegossen oder extrudiert wird. Die so erhaltenen Grünkörper werden dann gesintert.

Wie weiter oben ausgeführt, werden bei allen diesen herkömmlichen Formgebungsverfahren nur Produkte mit einer niedrigen kritischen Stromdichte erhalten.

Aufgabe der vorliegenden Erfindung ist die Bereitstellung eines Verfahrens der eingangs genannten Art, bei dem mit in der technischen Keramik herkömmlichen Formgebungsverfahren Formkörper beliebiger Gestalt mit einer kritischen Stromdichte über 1000 A/cm² hergestellt werden können.

Ausgehend von dem eingangs genannten Verfahren wird diese Aufgabe dadurch gelöst, daß als oxidkeramisches Pulver eine Mischung verwendet wird von Teilchen (a) mit einer durchschnittlichen Korngröße kleiner als 10 »m und von Teilchen (b), die in wenigstens zwei Raumrichtungen unterschiedliche Abmessungen haben und in wenigstens einer Raumrichtung eine durchschnittliche Größe aufweisen, die größer ist als die durchschnittliche Korngröße der Teilchen (a). Bei den Teilchen (a) handelt es sich in diesem Fall um im wesentlichen sphärische Teilchen.

Haben die Teilchen (a) eine Form mit in wenigstens zwei Raumrichtungen unterschiedlichen Abmessungen, so haben die Teilchen (b) in wenigstens einer Raumrichtung eine durchschnittliche Größe, die größer ist als die durchschnittlliche Größe der Teilchen (a) in derjenigen Raumrichtung mit der größten Abmessung.

Bei dem Verfahren können alle supraleitenden oxidkeramischen Pulver eingesetzt werden. Vorzugsweise werden solche vom YBaCuO-Typ eingesetzt. Als supraleitende Materialien kommen zum Beispiel YBa₂Cu₃O₇₋ₓ, YBa₂Cu₄O₈₋ₓ, Y₂Ba₄Cu₇O₁₅₋ₓ, Bi₂(Sr,Ca)₂CuO₈₋ₓ, Bi₂(Sr,Ca)₃ Cu₂O₁₀₋ₓ, Bi₂(Sr,Ca)₄Cu₃O₁₂₋ₓ, Tl₂Ca₂Ba₂Cu₃O₁₀, Tl₂Ca Ba₂Cu₂O₈, Tl₂Ba₂CuO₆, Ba₀,₆K₀,₄BiO₃ und Pb₂Sr₂LnCu₃O₈₊ₓ in Frage. Ferner kann von oxidkeramischen Pulvern ausgegangen werden mit einer Bruttozusammensetzung, die gegebenenfalls mit Ausnahme des Sauerstoffgehalts der eines keramischen Supraleiters entspricht. In diesem Fall werden beim Sintern höhere Temperaturen angewandt, um die supraleitenden Verbindungen zu erhalten.

Die Mischung enthält vorzugsweise wenigstens 10 Gew.-% der Teilchen (b) und besonders bevorzugt wenigstens 20 Gew.-% der Teilchen (b).

Als Teilchen (b) mit in wenigstens zwei Raumrichtungen unterschiedlichen Abmessungen können zum Beispiel stäbchen-, nadel- oder plättchenförmige Teilchen verwendet werden. Die Herstellung von Teilchen mit in wenigstens zwei Raumrichtungen unterschiedlichen Abmessungen ist bekannt. Für plättchenförmige Teilchen wird zum Beispiel auf Murugaraj et al. Solid State Ionics 32/33 (1989) 1183-1187 verwiesen . Bei Stäbchen, Nadeln oder Plättchen mit etwa rundem Querschnitt unterscheiden sich die Abmessungen in zwei Raumrichtungen. Bei Stäbchen mit ovalem Querschnitt und länglichen Plättchen unterscheiden sich die Abmessungen in allen drei Raumrichtungen. Wesentlich ist, daß aufgrund der unterschiedlichen Abmessungen in wenigstens zwei Raumrichtungen unter der Einwirkung der Kräfte beim Formgebungsverfahren eine Ausrichtung der Teilchen (b) in Richtung der Formgebungsachse erfolgt.

Als Teilchen (a) können entweder im wesentlichen kugelförmige Teilchen oder Teilchen verwendet werden, die wie die Teilchen (b) in wenigstens zwei Raumrichtungen unterschiedliche Abmessungen haben. Bei Verwendung kugelförmiger Teilchen (a) weisen die Teilchen (b) in wenigstens einer Raumrichtung eine durchschnittliche Größe auf, die größer ist als die durchschnittliche Korngroße der Teilchen (a). Bei Verwendung von stäbchen-, nadel- oder plättchenförmigen Teilchen (a) weisen die Teilchen (b) in wenigstens einer Raumrichtung eine durchschnittliche Größe auf, die größer ist als die durchschnittliche Größe der Teilchen (a) in ihrer Raumrichtung mit der größten Abmessung. Vorzugsweise weisen die Teilchen (b) in wenigstens einer Raumrichtung eine durchscnittliche Korngröße auf, die mindestens 1,5 mal größer ist als die durchschnittliche Korngröße der Teilchen (a), bzw. die durchschnittliche Größe der Teilchen (a) in deren Raumrichtung mit der größten Abmessung. Die Teilchen (b) können aber eine durchschnittliche Größe in wenigstens einer Raumrichtung aufweisen, die wesentlich größer ist als das 1,5-fache der durchschnittlichen Korngröße der Teilchen (a), beziehungsweise der durchschnittlichen Größe der Teilchen (a) in deren Raumrichtung mit der größten Abmessung, zum Beispiel können sie 5- oder 6-mal so groß sein. Die Wahl des Größenunterschieds richtet sich nach der Größe der Teilchen (a). Bei sehr kleinen Teilchen (a) verwendet man ein höheres Vielfaches als bei größeren Teilchen (a).

Die Teilchen (a) haben vorzugsweise eine durchschnittliche Korngröße kleiner als 5 »m und besonders bevorzugt kleiner als 3 »m. Die Teilchen (b) haben vorzugsweise eine durchschnittliche Korngröße kleiner als 30 »m und besonders bevorzugt kleiner als 15 »m. Die durchschnittliche Korngröße kann zum Beispiel mit einem Sedigraph bestimmt werden.

Bevorzugt bestehen die Teilchen (a) und die Teilchen (b) aus demselben oxidkeramischen Material.

Bei den Teilchen (a) und (b) verwendet man vorzugsweise Pulver mit enger Korngrößenverteilung.

Das aus der Mischung der Teilchen (a) und Teilchen (b) bestehende oxidkeramische Pulver bereitet man je nach dem zu verwendenden Formgebungsverfahren in bekannter Weise zu formbaren Massen, wie Schlickern, sprühgetrockneten Körnern oder knetbaren Massen auf. Dabei ist darauf zu achten, daß die

Teilchen (b) nicht in ihrer Morphologie zerstört werden. Eine Zerstörung der plättchen-, nadel- oder stäbchenförmigen Partikel kann zum Beispiel durch unsachgemäßes Mahlen oder Kneten erfolgen. Bei der Aufbereitung haben sich beispielsweise abriebfeste Kugelmühlen bewährt. Sie erlauben eine gute Homogenisierung der Additive, ohne das oxidkeramische Pulver anzugreifen. Besonders schonend ist die Durchmischung, wenn das Verhältnis von Feststoff zu Mahlkörpern kleiner als 0,5 ist.

Zur Formgebung können erfindungsgemäß alle in der Keramik üblichen Verfahren angewandt werden, bei denen auf die formbare Masse Scherkräfte ausgeübt werden, so daß die Teilchen (b) ausgerichtet werden. Entlang der ausgerichteten Teilchen (b) können sich dann die Teilchen (a) anlagern, die sofern sie nicht sphärisch sind, ebenfalls bei der Formgebung ausgerichtet werden.

Die Formgebung kann durch Pressen Extrusion, Foliengießen oder Spritzguß erfolgen. Die Scherkräfte sollten bei der Formgebung möglichst hoch sein, um eine gute Ausrichtung der Teilchen (b) in Richtung der Formgebungsachse zu erzielen.

Beim Foliengießen tritt eine Scherung zwischen Gießband und Rakel auf.

Bei Anwendung des Foliengießverfahrens wird das oxidkeramische Pulver aus den Teilchen (a) und (b) in einem Dispersionsmittel unter Zusatz eines Dispergators dispergiert und dann mit einem Bindemittel versehen. Ferner können Weichmacher zugesetzt werden. Die Mengenverhältnisse von Dispersionsmittel, oxidkeramischem Pulver und Zusätzen werden so gewählt, daß eine zäh fließende formbare Masse mit einer Viskosität im Bereich von 3000 bis 8000 mPa.s, bevorzugt um etwa 5000 mPa.s entsteht. Diese Masse wird dann zu einer Grünfolie gegossen.

Bei Anwendung des Extrusions-, Spritzguß- oder Trockenpreß-verfahrens wird zunächst ein dünnflüssiger Schlicker aus dem oxidkeramischen Pulver, Dispersionsmitteln und gegebenenfalls Zusätzen hergestellt, der eine Viskosität kleiner als 500 mPa.s hat. Der Schlicker wird dann zu einem rieselfähigen Pulver sprühgetrocknet, das direkt als formbare Masse zum Grünkörper trockengepreßt oder nach Zusatz von Gleitmitteln, Plastifizierern und Bindemitteln zum Grünkörper extrudiert oder spritzgegossen wird.

Die Grünkörper werden anschließend gesintert. Da während des Herstellungsverfahrens der Formkörper die supraleitenden Eigenschaften verschlechtert werden oder ganz verloren gehen können, kann es notwendig sein, nach der Sinterung einen Temperschritt in sauerstoffhaltiger Atmosphäre durchzuführen. Falls von einem oxidkeramischen Pulver ausgegangen wird, das nicht supraleitend ist, sondern nur eine Bruttozusammensetzung aufweist, die der eines keramischen Supraleiters entspricht, gegebenenfalls mit Ausnahme des Sauerstoffgehalts, wird der Grünkörper bei höheren Temperaturen als üblich in sauerstoffhaltiger Atmosphäre gesintert und anschließend getempert.

Beim erfindungsgemäßen Verfahren werden Formkörper aus supraleitendem oxidkeramischem Material mit kritischen Stromdichten von über 1000 A/m², meistens sogar von über 1500 A/m² erhalten. Bei der Bestimmung der kritischen Stromdichte hat man sich auf ein Spannungskriterium von 1 »V geeinigt.

Oxidkeramische Pulver in Form von sphärischen Teilchen (auch einer durchschnittlichen Korngröße unter 10 »m) können über die Sol-Gel-Synthese hergestellt werden. Oxidkeramische Pulver in Plättchenform sind z.B. nach dem von P. Bermis et al. angegebenen Verfahren erhältlich (vgl. "Molten Salt Synthesis of plate shaped YBa₂Cu₃O₇₋ₓ fine crystalline powders, in Proc. ICMC, 1990, 9.-11.5.1990 in Garmisch-Partenkirchen).
Pulver der Zusammensetzung YBa₂Cu₃O₇₋ₓ bestehend aus nadelförmigen Teilchen können von der Firma HiTc Superconco, Tullytown, Pa., USA, z.B. als Grade SC-P6.5 bezogen werden.
Das Gewichtsverhältnis (a)/(b) beträgt vorzugsweise 90:10 bis 25:75, insbesondere 90:10 bis 50:50.

Es ist vorteilhaft, wenn die Teilchen (a) und (b) etwa gleiche Dichte haben, damit sich die zum Foliengießen verwendeten Schlicker nicht entmischen.
Die Teilchen (a) und (b) sollen unterschiedliche Abmessungen und unterschiedliche Form aufweisen. Die Teilchen (a) sind vorzugsweise sinteraktiver als die Teilchen (b).
Die Teilchen (b) sollen während des Formgebungsprozesses (Foliengießung, Extrudieren, Spritzguß) orientiert werden und beim Sintern auf Kosten der sinteraktiveren Körner (a) wachsen.

Die Erfindung wird anhand der folgenden Beispiele näher erläutert.

### Vergleichsbeispiel

1000g supraleitendes YBa₂Cu₃O_{6,93}-Pulver mit einer durchschnittlichen Korngröße von 4 »m (der d50-Wert wurde mit einem Sedigraph in Sedisperse A 11 bestimmt) und einer im wesentlichen sphärischen Teilchenform wurden in 220 g Toluol und 80 g Ethanol unter Zusatz von 10 g Dispergator (Hypermer KD 1 R ®) in einer Kugelmühle mit Zirkoniumdioxid-Mahlkugeln dispergiert. Danach wurden 45 g Polyvinylbutyral als Bindemittel und 30 g Dioctylphthalat als Weichmacher zugesetzt und innerhalb von 24 Stunden in die Dispersion eingearbeitet. Die erhaltene formbare Masse hatte eine Viskosität von 4000 mPa.s. Nach Entfernung der eingeschlossenen Luft durch Vakuumbehandlung wurde die Masse zu einer Folie nach der Foliengießtechnik vergossen. Dabei wurden die Gießbedingungen so gewählt, daß eine Folienstärke von 0,4 mm erreicht wurde. Die Gießgeschwindigkeit betrug 110 cm/min.

Die Grünfolie wurde bei 930°C 10 Stunden lang gesintert und hatte 92 % der theoretischen Dichte. Nach einer Temperung an Luft bei 400°C 30 Stunden lang wurden die elektrischen Daten der Folie ermittelt. Die Folie hatte eine kritische Temperatur von 91 K und eine kritische Stromdichte von 430 A/m².

### Beispiel

Es wurde eine Mischung von 1000 g supraleitendem YBa₂Cu₃O_{6,93}-Pulver hergestellt aus 600 g YBa₂Cu₃O_{6,93}-Pulver mit einer durchschnittlichen Korngröße von 1,2 »m (der d50-Wert wurde mit einem Sedigraph in Sedisperse A 11 bestimmt) und einer im wesentlichen sphärischen Teilchenform und 400 g YBa₂Cu₃O_{6,93}-Pulver mit einer durchschnittlichen Korngröße von 6 »m (der d50-Wert wurde mit einem Sedigraph in Sedisperse A 11 bestimmt), wobei dies Pulver eine plättchenförmige Morphologie besaß. Die durchschnittliche Stärke der Plättchen lag bei 2 »m (bestimmt durch Rasterelektronenmikroskop).

Die Pulvermischung wurde schonend 24 h lang in einem Gemisch aus 220 g Toluol, 80 g Ethanol und 10 g Dispergator (Hypermer KD 1 R) in einer Kugelmühle mit ZirkoniumdioxidMahlkugeln homogenisiert und dispergiert. Danach wurden 45 g Polyvinylbutyral als Bindemittel und 30 g Dioctylphthalat als Weichmacher 24 h in die Dispersion eingearbeitet. Die erhaltene formbare Masse hatte eine Viskosität von 5000 mPa·s.

Nach Entfernung der eingeschlossenen Luft durch Vakuumbehandlung wurde die Masse zu einer Folie nach der Foliengießtechnik vergossen. Dabei wurden die Gießbedingungen so gewählt, daß eine Folienstärke von 0,4 mm erzielt wurde. Die Gießgeschwindigkeit betrug 110 cm/min..

Die Grünfolie wurde bei 930°C 10 Stunden lang gesintert und hatte 93 % der theoretischen Dichte. Nach einer Temperung an Luft bei 400°C 30 Stunden lang wurden die elektrischen Daten der Folie ermittelt. Die Folie hatte eine kritische Temperatur von 92 K und eine kritische Stromdichte von 5800 A/m²

## Patentansprüche

1. Verfahren zur Herstellung von Formkörpern aus supraleitendem oxidkeramischen Material, bei dem supraleitendes oxidkeramisches Pulver oder oxidkeramisches Pulver mit einer Bruttozusammensetzung, die gegebenenfalls mit Ausnahme des Sauerstoffgehaltes der eines keramischen Supraleiters entspricht, zu einer formbaren Masse aufbereitet wird, die formbare Masse zu einem Grünkörper verformt wird und der Grünkörper gesintert wird, dadurch gekennzeichnet, daß als oxidkeramisches Pulver eine Mischung verwendet wird von Teilchen (a), die eine durchschnittliche Korngröße von kleiner als 10 »m aufweisen und in wenigstens zwei Raumrichtungen unterschiedliche Abmessungen haben, und von Teilchen (b), die in wenigstens zwei Raumrichtungen unterschiedliche Abmessungen haben und in wenigstens einer Raumrichtung eine durchschnittliche Größe aufweisen, die größer ist als die durchschnittliche Größe der Teilchen (a) in deren Raumrichtung mit einer größten Abmessung.

2. Verfahren nach Anspruch 1, dadurch gekennzeichnet, daß die Mischung wenigstens 10 Gew.-% der Teilchen (b) enthält.

3. Verfahren nach Anspruch 2, dadurch gekennzeichnet, daß die Mischung wenigstens 20 Gew.-% der Teilchen (b) enthält.

4. Verfahren nach einem der Ansprüche 1 bis 3, dadurch gekennzeichnet, daß die Teilchen (b) in wenigstens einer Raumrichtung eine durchschnittliche Größe aufweisen, die mindestens 1,5-mal größer ist als die durchschnittliche Korngröße der Teilchen (a) in deren Raumrichtung mit der größten Abmessung.

5. Verfahren nach einem der Ansprüche 1 bis 4, dadurch gekennzeichnet, daß die Teilchen (b) aus demselben oxidkeramischen Material bestehen wie die Teilchen (a).

6. Verfahren nach einem der Ansprüche 1 bis 5, dadurch gekennzeichnet, daß die Teilchen (b) plättchenförmig sind.

7. Verfahren nach einem der Ansprüche 1 bis 6, dadurch gekennzeichnet, daß die Teilchen (b) eine durchschnittliche Korngröße kleiner als 30 »m haben.

8. Verfahren nach Anspruch 7, dadurch gekennzeichnet, daß die Teilchen (b) eine durchschnittliche Korngröße kleiner als 15 »m haben.

9. Verfahren nach einem der Ansprüche 1 bis 8, dadurch gekennzeichnet, daß die Teilchen (a) eine durchschnittliche Korngröße kleiner als 5 »m haben.

10. Verfahren nach Anspruch 9, dadurch gekennzeichnet, daß die Teilchen (a) eine durchschnittliche Korngröße kleiner als 3 »m haben.

11. Verfahren nach einem der Ansprüche 1 bis 10, dadurch gekennzeichnet, daß der gesinterte Körper anschließend getempert wird.

12. Verfahren nach einem der Ansprüche 1 bis 11, dadurch gekennzeichnet, daß die formbare Masse unter Einwirkung von Scherkräften zum Grünkörper verformt wird.

## Claims

1. A process for producing moldings of superconducting oxidic ceramic material, in which superconducting oxidic ceramic powder or oxidic ceramic powder having an overall composition which, possibly with the exception of the oxygen content, corresponds to that of a ceramic superconductor is processed to produce a moldable material, the moldable material is molded to produce a compact and the compact is sintered, which process comprises using as oxidic ceramic powder a mixture of particles (a) which have a mean particle size of less than 10 »m and have different dimensions in at least two spatial directions and of particles (b) which have different dimensions in at least two spatial directions and have, in at least one spatial direction, a mean size which is greater than the mean size of the particles (a) in their spatial direction having the greatest dimension.

2. The process as claimed in claim 1, wherein the mixture contains at least 10% by weight of the particles (b).

3. The process as claimed in claim 2, wherein the mixture contains at least 20% by weight of the particles (b).

4. The process as claimed in any of claims 1 to 3, wherein the particles (b) have, in at least one spatial direction, a mean size which is at least 1.5 times greater than the mean particle size of the particles (a) in their spatial direction having the greatest dimension.

5. The process as claimed in any of claims 1 to 4, wherein the particles (b) are composed of the same oxidic ceramic material as the particles (a).

6. The process as claimed in any of claims 1 to 5, wherein the particles (b) are platelet-like.

7. The process as claimed in any of claims 1 to 6, wherein the particles (b) have a mean particle size of less than 30 »m.

8. The process as claimed in claim 7, wherein the particles (b) have a mean particle size of less than 15 »m.

9. The process as claimed in any of claims 1 to 8, wherein the particles (a) have a mean particle size of less than 5 »m.

10. The process as claimed in claim 9, wherein the particles (a) have a mean particle size of less than 3 »m.

11. The process as claimed in any of claims 1 to 10, wherein the sintered body is subsequently annealed.

12. The process as claimed in any of claims 1 to 11, wherein the moldable material is deformed to produce the compact by exposure to shearing forces.

## Revendications

1. Procédé de préparation de corps façonnés ou moulés en un matériau supraconducteur formé par des oxydes céramiques, procédé dans lequel on prépare une poudre supraconductrice d'oxydes céramiques ou une poudre d'oxydes céramiques ayant une composition brute qui correspond, éventuellement à l'exclusion de la teneur en oxygène, à la composition d'un supraconducteur céramique, pour obtenir une composition moulable, on applique une mise en forme à la composition moulable pour obtenir un corps "vert" et l'on fritte ce corps vert, procédé caractérisé en ce qu'on utilise, comme poudre d'oxydes céramiques un mélange de particules (a) ayant une grosseur moyenne des grains inférieure à 10 »m et ayant des mesures différentes dans au moins deux directions spatiales, et de particules (b) qui ont des mesures différentes dans au moins deux directions spatiales, et présentent dans au moins une direction spatiale une grandeur moyenne qui est supérieure à la grandeur moyenne des particules (a) dans la direction spatiale où ces dernières particules ont leur plus grande cote ou mesure.

2. Procédé selon la revendication 1, caractérisé en ce que le mélange contient au moins 10 % en poids des particules (b).

3. Procédé selon la revendication 2, caractérisé en ce que le mélange contient au moins 20 % en poids des particules (b).

4. Procédé selon l'une des revendications 1 à 3, caractérisé en ce que les particules (b) présentent dans au moins une direction spatiale, une grandeur moyenne qui est au moins 1,5 fois plus grande que la grandeur moyenne des grains des particules (a) dans la direction spatiale où ces dernières ont leur plus grande mesure ou cote.

5. Procédé selon l'une des revendications 1 à 4, caractérisé en ce que les particules (b) consistent en le même matériau d'oxydes céramiques que les particules (a).

6. Procédé selon l'une des revendications 1 à 5, caractérisé en ce que les particules (b) sont en forme de plaquettes.

7. Procédé selon l'une des revendications 1 à 6, caractérisé en ce que les particules (b) ont une grosseur moyenne des grains inférieure à 30 »m.

8. Procédé selon la revendication 7, caractérisé en ce que les particules (b) ont une grosseur moyenne des grains inférieure à 15 »m.

9. Procédé selon l'une des revendications 1 à 8, caractérisé en ce que les particules (a) ont une grosseur moyenne des grains inférieure à 5 »m.

10. Procédé selon la revendication 9, caractérisé en ce que les particules (a) ont une grosseur moyenne des grains inférieure à 3 »m.

11. Procédé selon l'une des revendications 1 à 10, caractérisé en ce que le corps fritté est ensuite soumis à tempérage .

12. Procédé selon l'une des revendications 1 à 11, caractérisé en ce que la composition formable est mise en forme sous l'action de forces de cisaillement pour donner un corps "vert" .
